# FASCICULE DE BREVET EUROPEEN

(11) **EP 1 332 557 B1**
(45) Date de publication et mention de la délivrance du brevet: **09.02.2005**
(21) Numéro de dépôt: 01993977.6
(22) Date de dépôt: 09.11.2001
(51) Int. Cl.: H03M 1/00

(54) **MODULE, DISPOSITIF ET PROCEDE DE DECODAGE A HAUT DEBIT, D'UN CODE CONCATENE**
MODUL, VORRICHTUNG UND VERFAHREN ZUM HOCHBITRATIGEN DEKODIEREN EINES VERKETTETEN CODES
HIGH-SPEED MODULE, DEVICE AND METHOD FOR DECODING A CONCATENATED CODE

(30) Priorité: 10.11.2000 FR 0014521
(43) Date de publication de la demande: 06.08.2003
(73) Titulaire: FRANCE TELECOM, 75015 Paris (FR); Groupe des Ecoles de Telecommunications-Etablissement ENST de Bretagne, 75634 Paris Cédex 13 (FR)
(72) Inventeur: ADDE, Patrick, F-29200 BREST (FR); PYNDIAH, Ramesh, F-29280 PLOUZANE (FR)
(74) Mandataire: Vidon, Patrice
(86) Numéro de dépôt international: PCT/FR2001/003509
(87) Numéro de publication internationale: WO 2002/039587

(56) Documents cités:
- EP-A- 1 024 601
- EP-A- 1 030 457
- US-A- 6 065 147
- OKUDA T ET AL: "A FOUR-LEVEL STORAGE 4-GB DRAM" IEEE JOURNAL OF SOLID-STATE CIRCUITS, IEEE INC. NEW YORK, US, vol. 32, no. 11, 1 novembre 1997 (1997-11-01), pages 1743-1747, XP000752885 ISSN: 0018-9200

## Description

Le domaine de l'invention est celui du codage de données numériques appartenant à une, ou plusieurs, séquences de données sources destinées à être transmises, ou diffusées, notamment en présence de bruits d'origines diverses, et du décodage des données codées ainsi transmises.

Plus précisément, l'invention concerne une amélioration de la technique de décodage des codes notamment connus sous le nom de « turbo-code » (marque déposée), et plus particulièrement de l'opération de décodage itératif des codes concaténés.

La transmission de l'information (données, image, parole,...) repose de plus en plus sur les techniques numériques de transmission. De nombreux efforts ont été faits en matière de codage de source pour réduire le débit numérique, tout en conservant une bonne qualité. Ces techniques nécessitent bien sûr une meilleure protection des éléments binaires vis-à-vis des perturbations liées à la transmission. L'utilisation de codes correcteurs d'erreurs puissants dans ces systèmes de transmission se révélait indispensable. C'est notamment dans ce but qu'a été proposée la technique des « turbo-codes ».

Le principe général des « turbo-codes » est notamment présenté dans le brevet français n° FR-91 05280, ayant pour titre « Procédé de codage correcteur d'erreurs à au moins deux codages convolutifs systématiques parallèles, procédé de décodage itératif, module de décodage et décodeur correspondants », et dans l'article de C. Berrou, A. Glavieux et P. Thitimajshima intitulé « Near Shannon limit error-correcting coding and decoding : Turbo-codes » publié dans IEEE International conderence on Communication, ICC'93, vo12/3, pages 1064 à 1071 en mai 1993. Un état de l'art est rappelé dans l'article de C. Berrou et A. Glavieux « Near Optimum Error Correcting Coding and Decoding : « Turbo-Codes » (IEEE Transactions on Communications, Volume 44, n° 10, pages 1261-1271, Octobre 1996).

Selon cette technique, on propose la mise en oeuvre d'un codage à « concaténation parallèle », s'appuyant sur l'utilisation d'au moins deux codeurs élémentaires. Cela permet de disposer, lors du décodage, de deux symboles de redondance issus de deux codeurs distincts. Entre les deux codeurs élémentaires, on met en oeuvre des moyens de permutation, de façon que chacun de ces codeurs élémentaires soit alimenté par les mêmes données numériques source, mais prises dans des ordres différents.

Un complément à ce type de technique, permettant d'obtenir des codes appelés des « turbo-codes » en blocs ou TCB, est destinée au codage en blocs (codes concaténés). Cette technique améliorée est décrite dans l'article de R. Pyndiah, A. Glavieux, A. Picart et S. Jacq dans l'article « Near optimum decoding of product code » (publié dans IEEE Transactions on Communications, vol 46, n° 8 pages 1003 à 1010 en août 1998), dans le brevet FR-93 13858, ayant pour titre « Procédé pour transmettre des bits d'information en appliquant des codes en blocs concaténés», ainsi que dans l'article de O. Aitsab et R. Pyndiah « Performance of Reed Solomon block turbo-code » (IEEE Globecom'96 Conference, Vol. 1/3, pages 121-125, Londres, Novembre 1996).

Cette technique repose, en particulier, sur l'utilisation de codes produits introduits par P. Elias et décrits dans son article « Error-free coding » paru dans la revue « IRE Transaction on Information Theory » (vol. IT4, pages 29-27) en septembre 1954. Les codes produits sont basés sur la concaténation série de codes en blocs. Pendant longtemps, on a décodé les codes produits suivant des algorithmes à entrées et sorties dures, c'est-à-dire qu'un décodeur élémentaire de codes en blocs accepte en entrée et fournit en sortie des éléments binaires.

Pour décoder les « turbo-codes » en blocs, on a envisagé d'utiliser des moyens de décodage à entrées et sorties douces, c'est-à-dire qu'un décodeur élémentaire de codes en blocs accepte en entrée et fournit en sortie des éléments non binaires, pondérés en fonction de leur vraisemblance.

Les « turbo-codes » en bloc sont particulièrement attractifs lorsque le codage des données s'appliquent sur des blocs de petite taille (par exemple inférieure à 100 bits) ou lorsque le rendement du code (c'est-à-dire le nombre de bits de données utiles divisé par le nombre de bits de données codées, par exemple, 0,95) est élevé et que le taux d'erreurs visé est faible. En effet, le niveau de performance du code, mesuré généralement en termes de taux d'erreurs résiduel en fonction d'un rapport signal/bruit donné, varie en fonction de la distance de Hamming minimale du code qui est très bonne dans le cas des « turbo-codes » en blocs (9,16,24, 36 voire plus).

Les différentes techniques de « turbo-décodage » sont de plus en plus intéressantes pour les systèmes de communication numériques qui nécessitent une fiabilité toujours plus grande. En outre, les débits de transmission sont de plus en plus élevés. On peut atteindre notamment, avec l'utilisation de canaux de transmission sur fibres optiques, des débits atteignant des gigabits voire des térabits.

On connaît, dans l'état de la technique, deux différents types d'architecture de décodeurs pour « turbo-codes » en blocs ayant pour base:
- une structure modulaire ; ou
- une structure de Von Neumann.

Dans la structure modulaire, on cascade des modules ou décodeurs élémentaires, chacun de ces modules ayant en charge une demi-itération. Ce traitement est bien adapté aux algorithmes de décodage à entrées et sorties pondérées dans la mesure où de nombreuses fonctions dans ces algorithmes sont classiquement réalisées de manière séquentielle et sont alors simples à implanter.

Un inconvénient majeur de cette technique de l'art antérieur est qu'elle introduit une latence importante dans le traitement des données, la latence étant le nombre d'échantillons qui sortent du décodeur avant qu'une donnée présente en entrée ne se retrouve à son tour en sortie. Cette latence augmente avec le nombre de modules. En outre, l'encombrement du circuit est lui aussi relativement important et s'accroît avec le nombre de modules. Les paramètres de latence et d'encombrements du circuit deviennent vite rédhibitoires quand le nombre d'itérations et/ou la longueur du code augmentent.

Dans la structure de Von Neumann, le circuit réalise plusieurs itérations en utilisant une seule unité de mémorisation et une seule unité de traitement pour l'ensemble des itérations. On vient reboucler sur lui-même un module de décodage élémentaire. Avec cette architecture, le nombre de mémoires nécessaire est réduit. Le gain en surface de circuit de mémorisation est considérable puisque la surface de mémorisation est indépendante du nombre d'itérations. Néanmoins, un inconvénient majeur de cette structure est qu'elle entraîne une diminution du débit de données.

L'invention selon ses différents aspects a notamment pour objectif de pallier ces inconvénients de l'art antérieur.

Plus précisément, un objectif de l'invention est de fournir un module, un procédé et un dispositif de décodage qui soient adaptés à fournir de bonnes performances en termes de taux d'erreurs, tout en limitant la surface du circuit nécessaire pour les opérations de traitement (décodages élémentaires) et les mémoires.

Un autre objectif de l'invention est de fournir un module, un procédé et un dispositif de décodage qui puisse traiter des hauts débits pour une fréquence d'horloge de fonctionnement donnée.

L'invention a aussi pour objectif la diminution de la latence de décodage, dans un tel module, procédé et dispositif de décodage.

Ces objectifs ainsi que d'autres qui apparaîtront par la suite sont atteints, à l'aide d'au moins un module de décodage d'un code concaténé, correspondant à au moins deux codes élémentaires, du type mettant en oeuvre des moyens de mémorisation dans lesquels sont stockés des échantillons de données à décoder. Selon l'invention, le module comprend au moins deux décodeurs élémentaires pour au moins un desdits codes élémentaires, les décodeurs élémentaires associés à l'un desdits codes élémentaires traitant simultanément, en parallèle, des mots de code distincts contenus dans les moyens de mémorisation.

Ainsi, l'invention repose sur une approche tout à fait nouvelle et inventive du décodage dans lequel on duplique, dans un module, le nombre de décodeurs sans dupliquer le nombre de moyens de mémorisation, ce qui représente un avantage par rapport à l'état de l'art où l'homme du métier duplique naturellement le nombre de mémoires et de décodeurs pour augmenter les débits alors que c'est la mémoire qui occupe le plus de place dans un circuit de décodage (par exemple, la mémoire peut occuper 80% de la surface totale du circuit).

L'invention s'applique avantageusement à des décodeurs itératifs et en particulier aux « turbo-décodeurs ». L'invention peut s'appliquer à différentes structures de décodeurs, notamment à des structures de Von Neumann (dans lesquels des mémoires de réception et/ou de traitement des données ainsi que des unités de traitement sont utilisées pour plusieurs itérations, ce qui permet une économie de surface de circuit mais qui, pour une vitesse de fonctionnement donnée, limite la vitesse de décodage) et à des structures modulaires (dans lesquels des mémoires de réception et/ou de traitement des données ainsi que des unités de traitement sont utilisées pour une seule demi-itération ce qui permet un gain de vitesse de décodage mais conserve une latence de décodage importante), ces structures étant détaillées plus loin.

D'une manière générale, l'invention présente l'intérêt d'un gain en vitesse de décodage (cas notamment de l'invention appliquée à une structure de Von Neumann, la vitesse étant le principal problème de la structure de Von Neumann) et/ou un gain de la latence de décodage (cas notamment de l'invention appliquée à une structure modulaire), tout en maintenant une surface de circuit relativement petite.

Ainsi, l'invention permet d'obtenir des hauts débits de transmission de données.

Selon une caractéristique avantageuse, les moyens de mémorisation stockant lesdites données à décoder étant organisés sous la forme d'une matrice de n₁ lignes contenant chacune un mot de code élémentaire et n₂ colonnes contenant chacune un mot de code élémentaire, le module de décodage comprend n₁ décodeurs élémentaires (respectivement n₂) alimentés chacun par une des lignes (respectivement colonnes) de la matrice.

En d'autres termes, l'invention s'applique avantageusement aux codes concaténés série.

Selon une caractéristique particulière, le module de décodage, les moyens de mémorisation étant organisés sous la forme d'une matrice de *n*₁ lignes dont *k*₁ lignes contenant chacune un mot de code élémentaire et *n*₂ colonnes dont *k*₂ colonnes contenant chacune un mot de code élémentaire, est remarquable en ce qu'il comprend *k*₁ décodeurs élémentaires (respectivement *k*₂) alimentés chacun par une des lignes (respectivement colonnes) de la matrice.

Ainsi, l'invention s'applique avantageusement aux codes concaténés parallèles.

Elle permet également un décodage en parallèle des lignes (respectivement colonnes) d'une matrice correspondant au code utilisé, améliorant ainsi la vitesse de décodage ou diminuant la latence, tout en maintenant une surface de circuit relativement faible, les décodeurs élémentaires requérant généralement une surface de circuit faible (ou d'une manière générale un nombre de transistors faible) comparativement à la surface nécessaire pour les mémoires de réception et de traitement des données.

Selon une caractéristique préférentielle de l'invention, les moyens de mémorisation sont organisés de façon à permettre un accès simultané à au moins deux mots de code élémentaire.

Ainsi, des données correspondant à au moins deux mots de codes peuvent être traitées en parallèle lors des décodages élémentaires, ce qui permet un gain en vitesse et/ou une diminution de la latence.

Avantageusement, les moyens de mémorisation sont du type RAM simple port.

Ainsi, l'invention permet l'utilisation de mémoires courantes qui ne permettent pas l'accès à des données mémorisées à deux adresses distinctes et ne nécessite pas (même si elle ne l'interdit pas) l'utilisation de mémoires multiports.

De façon préférentielle, les moyens de mémorisation sont organisés en cases, possédant chacune une adresse unique et contenant chacune au moins deux données élémentaires d'un code élémentaire.

Ainsi, l'invention permet d'accéder à une seule case mémoire contenant au moins deux données élémentaires (d'une manière générale données binaires pondérées ou non), ces données pouvant être utilisées simultanément par au moins deux décodeurs élémentaires. Ceci permet d'avoir un accès simultané à des données dont le contenu est indépendant et de limiter ainsi la fréquence de fonctionnement (donc la consommation) des circuits de mémorisation tout en ayant une vitesse de décodage globale relativement élevée.

Selon une caractéristique avantageuse, le module de décodage permet un accès simultané à *m* mots de code élémentaire et à *l* mots de code élémentaire, *m*>1 et/ou *l*>1, permettant d'alimenter simultanément au moins deux décodeurs élémentaires.

Ainsi, l'invention permet avantageusement de tirer le meilleur parti de la découpe en codes élémentaires en ayant un décodeur élémentaire associé à chaque code élémentaire. L'invention permet ainsi d'optimiser la vitesse de décodage et/ou la latence.

Selon une caractéristique particulière, les mots accessibles simultanément correspondent à des lignes adjacentes et/ou à des colonnes adjacentes d'une matrice initiale à *n*₁ lignes et *n*₂ colonnes, chacune des lignes et/ou colonnes adjacentes contenant un mot de code élémentaire.

Selon un mode de réalisation particulier, les codes élémentaires sont le même code C.

Ainsi, l'invention permet d'optimiser la vitesse de décodage et/ou la latence lorsque les codes élémentaires sont identiques.

Avantageusement, le module de décodage est conçu de façon à effectuer au moins deux opérations de décodage élémentaire.

Selon un premier mode de réalisation, le code concaténé est un code concaténé série.

Selon second mode de réalisation, le code concaténé est un code concaténé parallèle.

Ainsi, l'invention peut s'appliquer aussi bien à ces deux types importants de codes concaténés.

L'invention concerne également un dispositif de décodage d'un code concaténé, mettant en oeuvre au moins deux modules tels que décrit précédemment, effectuant chacun une opération de décodage élémentaire.

L'invention concerne encore un procédé de décodage d'un code concaténé, correspondant à deux codes élémentaires, et comprenant au moins deux étapes simultanées de décodage élémentaire d'au moins un desdits codes alimentaires, alimentées par les mêmes moyens de mémorisation.

Selon une caractéristique avantageuse, le procédé de décodage est remarquable en ce que les moyens de mémorisation sont organisés de façon qu'un accès unique à une adresse des moyens de mémorisation donne accès à au moins deux mots de code élémentaire, de façon à alimenter simultanément au moins deux des étapes de décodage élémentaire.

Selon un mode de réalisation particulier, le procédé de décodage est itératif.

Préférentiellement, au moins certaines des données traitées sont pondérées.

Ainsi, l'invention est avantageusement utilisée dans le cadre des turbo-codes qui permettent notamment d'obtenir de bonnes performances en termes de taux d'erreur résiduel après décodage.

Les avantages des dispositifs et procédés de décodage sont les mêmes que ceux du module de décodage, et ne sont donc pas détaillés plus amplement.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1 présente une structure d'une matrice représentant un mot de code produit ou « turbo-code en blocs », conforme à l'invention selon un mode particulier de réalisation ;
- la figure 2 illustre un organigramme de décodage d'un « turbo-code » en bloc, connu en soi;
- la figure 3 présente schématiquement un schéma bloc d'une unité de traitement réalisant une demi-itération de « turbo-décodage », également connu en soi ;
- la figure 4 présente schématiquement un schéma bloc d'une unité de traitement réalisant une demi-itération de « turbo-décodage », également connu en soi;
- la figure 5 présente schématiquement un schéma bloc d'un module de turbo-décodeur dans une structure modulaire selon l'état de l'art ;
- la figure 6 présente schématiquement un schéma bloc d'un module de turbo-décodeur dans une structure modulaire avec mise en évidence de la structure des mémoires, selon l'état de l'art ;
- la figure 7 présente schématiquement un schéma bloc d'un module de turbo-décodeur dans une structure de Von Neumann avec mise en évidence de la structure des mémoires, selon l'état de l'art ;
- la figure 8 présente un schéma bloc de décodeur adapté aux hauts débits avec parallélisation de décodeurs, conforme à l'invention selon un premier mode particulier de réalisation ;
- la figure 9 illustre schématiquement une case mémoire, conforme à l'invention selon un deuxième mode particulier de réalisation ;
- la figure 10 illustre schématiquement une case mémoire avec son affectation à des unités de traitement, conforme à l'invention selon une variante d'un mode particulier de réalisation ;
- la figure 11 présente un schéma-bloc de turbo-décodeur, conforme à l'invention selon une variante d'un mode particulier de réalisation.

Le principe général de l'invention repose sur une architecture particulière des mémoires utilisées dans une opération de décodage de code concaténés et plus particulièrement de décodage de ces codes.

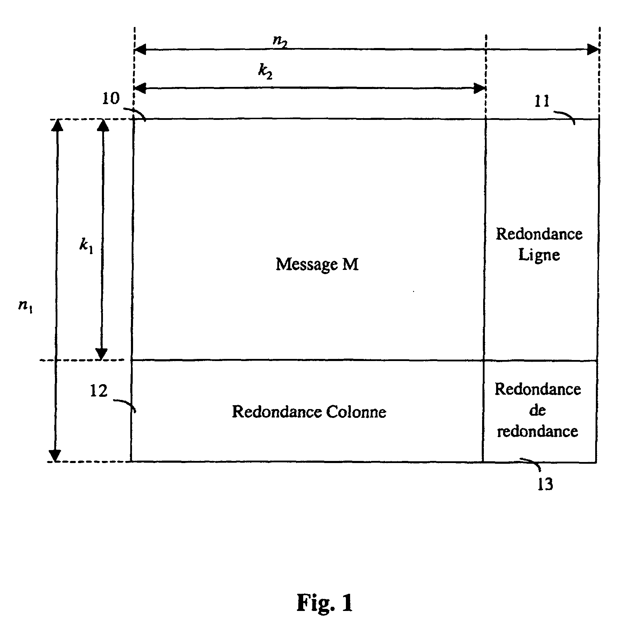

On rappelle d'abord qu'on peut représenter généralement, un code concaténé série sous la forme d'une matrice **[C]** binaire et de dimension 2 telle qu'illustrée en figure 1. Cette matrice **[C]** contient *n*₁ lignes et *n*₂ colonnes et :
- les échantillons binaires d'informations sont représentés par une sous-matrice 10, **[M]**, à *k*₁ lignes et *k*₂ colonnes ;
- chacune des *k*₁ lignes de la matrice **[M]** est codée par un code élémentaire *C*₂(*n*₂, *k*₂, δ₂) (la redondance est représentée par une sous-matrice 11 de redondance de ligne) ;
- chacune des *n*₂ colonnes de la matrice **[M]** et de la redondance ligne est codée par un code élémentaire *C*₁(*n*₁,*k*₁,*δ*₁) (la redondance correspondant aux échantillons binaires d'information est représentée par une sous-matrice 12 de redondance de colonne ; la redondance correspondant à la redondance ligne de la sous-matrice 11 est représentée par une sous-matrice 13 de redondance de redondance).

Si le code C₁ est linéaire, les (*n*₁-*k*₁) lignes construites par *C*₁ sont des mots du code de *C*₂ et peuvent donc être décodés comme les *k*₁ premières lignes. Un code concaténé série se caractérise par *n*₁ mots de code de *C*₂ suivant les lignes, et par *n*₂ mots de code de *C*₁ suivant les colonnes. Les codes *C*₁ et *C*₂ peuvent être obtenus à partir de codes élémentaires convolutifs utilisés comme codes en blocs ou de codes en blocs linéaires.

On décode les codes concaténés itérativement en décodant d'abord chacun des codes élémentaires suivant les lignes puis chacun des codes élémentaires suivant les colonnes.

Selon l'invention, pour améliorer le débit de décodage, on parallélise les décodeurs élémentaires :
- pour décoder les *n*₁ lignes, on utilise *m*₁ (2 ≤ *m*₁ ≤ *n*₁) décodeurs élémentaires du code *C*₂; et/ou
- pour décoder les *n*₂ colonnes, on utilise *m*₂ (2 ≤ *m*₂ ≤ *n*₂) décodeurs élémentaires du code *C*₁.

Chaque décodeur élémentaire a en entrée des données issues d'une mémoire de réception et/ou de traitement et fournit en sortie des données qui sont conservées dans une mémoire de réception et/ou de traitement. Afin d'améliorer encore le débit de décodage, en conservant une vitesse d'horloge de circuit qui reste raisonnable, on groupe plusieurs données en entrée ou en sortie de décodeur dans une seule case mémoire. Ainsi, en groupant par exemple 4 données élémentaires (chacune des données élémentaires correspondant à une donnée binaire pondérée ou non) dans une seule case-mémoire et en démultiplexant (respectivement multiplexant) ces données en entrée (respectivement sortie) des décodeurs ou en sortie (respectivement entrée) des mémoires, on multiplie par 4 le débit des données en entrée et en sortie de mémoire, pour une vitesse d'horloge de circuit donnée, ce qui permet d'augmenter globalement les vitesses de décodage et/ou de diminuer la latence.

L'invention s'applique de la même manière aux codes concaténés parallèles. On rappelle qu'on peut représenter généralement, un code concaténé parallèle sous la forme d'une matrice **[C]** binaire et de dimension 2 telle qu'illustrée en figure 1. Cette matrice **[C]** contient *n*₁ lignes et *n*_{*2*} colonnes et :
- les échantillons binaires d'informations sont représentés par une sous-matrice 10, **[M]**, à *k*₁ lignes et *k*₂ colonnes ;
- chacune des *k*₁ lignes de la matrice **[M]** est codée par un code élémentaire *C*₂(*n*₂, *k*₂, δ₂) (la redondance est représentée par une sous-matrice 11 de redondance de ligne) ;
- chacune des *k*₂ colonnes de la matrice **[M]** est codée par un code élémentaire *C*₁(*n*₁, *k*₁, δ₁) (la redondance correspondant aux échantillons binaires d'information est représentée par une sous-matrice 12 de redondance de colonne ; il n'y a pas de redondance de redondance dans le cas des codes concaténés parallèles).

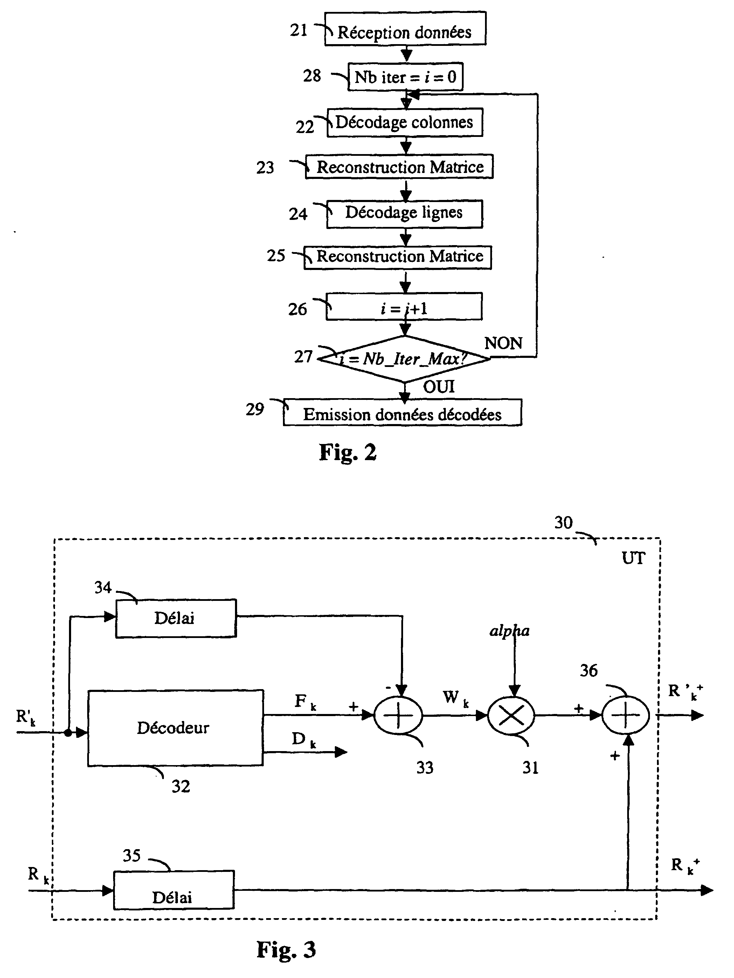

Le « turbo-décodage » d'un code correspondant à la matrice C de la figure 1 consiste à faire un décodage à entrée et sorties pondérées de toutes les lignes puis de toutes les colonnes de la matrice C, selon le processus itératif illustré en figure 2.

Après réception 21 des données à traiter, on effectue un nombre prédéterminé (*Nb_Iter_Max*) des opérations suivantes :
- décodage 22 des colonnes (une demi-itération ) ;
- reconstruction 23 de la matrice ;
- décodage 24 des lignes (une demi-itération) ;
- reconstruction 25 de la matrice.

Ces opérations sont donc répétées tant que le nombre *i* d'itérations, incrémenté (26) à chaque itération, est inférieur à *Nb_Iter_Max* (27), le nombre *i* ayant été préalablement initialisé à zéro (28).

Les données décodées, notées Dₖ, sont ensuite traitées (29).

De manière générale, les informations échangées d'une demi-itération 22, 25 à une autre sont définies par la figure 3.

Rₖ correspond à l'information reçue du canal, R'ₖ à l'information qui vient de la demi-itération antérieure et R'ₖ⁺ à l'information envoyée à la demi-itération suivante. La sortie de chaque demi-itération est donc égale à la somme 36 de Rₖ et de l'information extrinsèque, Wₖ, multipliée (31) ensuite par un coefficient, *alpha*, de contre-réaction ou de convergence. Cette information extrinsèque correspond à l'apport du décodeur 32. Elle est obtenue par différence 33 entre la sortie pondérée Fₖ du décodeur et l'entrée pondérée de ce même décodeur.

Des délais 34 et 35 sont prévus pour compenser la latence du décodeur 32.

On considère par la suite le décodeur à entrées et sorties pondérées comme un bloc ayant Rₖ et R'ₖ (échantillonnés sur *q* bits) comme entrées, délivrant R'ₖ⁺ et Rₖ⁺ (échantillonnés sur *q* bits) à la sortie avec une certaine latence *L* (retard nécessaire pour mettre en oeuvre l'algorithme de décodage). Il prend le nom d'Unité de Traitement (UT) 30.

Le décodeur 32 fournit par ailleurs une décision binaire Dₖ qui est utilisée lors de la dernière demi-itération d'une opération de « turbo-décodage » et qui correspond à une donnée décodée émise lors de l'opération 29 illustrée en regard de la figure 2.

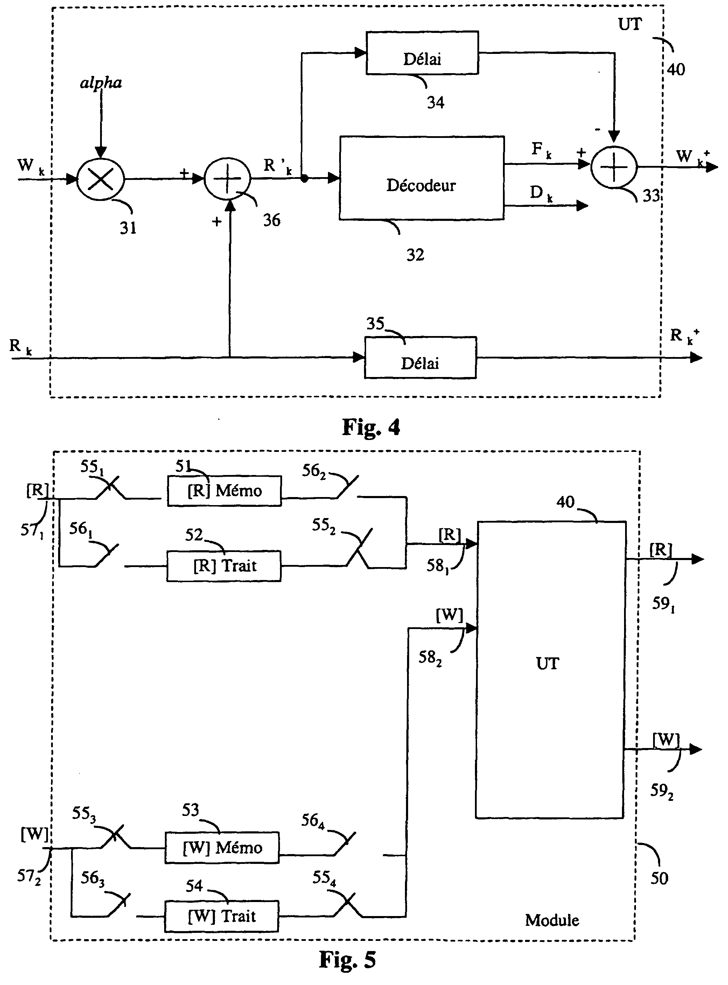

En considérant une autre découpe du schéma bloc de la figure 3, R'ₖ peut être remplacé par l'information extrinsèque Wₖ qui devient entrée-sortie de l'unité de traitement 40, R'ₖ toujours utilisée en entrée du décodeur 32, étant alors une variable interne. Cette variante est illustrée par la figure 4.

Comme déjà mentionné, une analyse fonctionnelle de l'algorithme de « turbo-décodage » permet d'identifier deux architectures possibles pour un circuit « turbo-décodeur » de code produit (l'une modulaire et l'autre s'apparentant à une machine dite de Von Neumann). Ces deux structures sont maintenant décrites un peu plus précisément.

### a) Structure modulaire

A partir du schéma de fonctionnement de l'algorithme, on peut imaginer pour le « turbo-décodeur » une structure modulaire dans laquelle chaque sous-circuit réalise une demi-itération de décodage (c'est-à-dire un décodage des lignes ou des colonnes d'une matrice de données, **[R]** et **[W]** ou **[R']**). Il faut mémoriser **[R]** et **[W]** (ou **[R'],** suivant le schéma bloc d'unité de traitement 30 ou 40 retenu).

Le circuit complet est alors constitué de modules identiques cascadés, tels qu'illustrés en figure 5. Pour 4 itérations par exemple, le circuit utilise 8 modules, ou décodeurs élémentaires.

Avec l'architecture modulaire, les données sont traitées séquentiellement (échantillon après échantillon). Ce traitement est bien adapté aux algorithmes de décodage à entrées et sorties pondérées dans la mesure où de nombreuses fonctions dans ces algorithmes sont classiquement réalisées de manière séquentielle et sont alors simples à implanter.

Chaque module introduit une latence de (*n*_{*1*}*n*_{*2*}+*L*) échantillons. La latence est le nombre d'échantillons qui sortent du décodeur avant qu'une donnée présente en entrée ne se retrouve à son tour en sortie. Dans cette expression, les *n*_{*1*}*n*_{*2*} premiers échantillons correspondent au remplissage d'une matrice de données et les *L* échantillons suivants au décodage proprement dit d'une ligne (ou colonne) de cette matrice.

### b) Structure de Von Neumann

La seconde architecture s'apparente à une machine séquentielle de Von Neumann. Elle utilise une seule et même unité de traitement pour réaliser plusieurs itérations. Par rapport à la précédente, cette solution vise principalement à réduire l'encombrement du « turbo-décodeur ». Elle présente en outre, l'avantage de limiter à 2.*n*_{*1*}*n*_{*2*} échantillons au maximum la latence globale introduite par le circuit, indépendamment du nombre d'itérations effectué (*n*_{*1*}*n*_{*2*} pour remplir une matrice et *n*_{*1*}*n*_{*2*} supplémentaires pour le décodage).

Chaque échantillon est traité séquentiellement et doit être décodé en un temps ne dépassant pas l'inverse du produit du débit des données par le nombre de demi-itérations à effectuer. Ainsi, pour quatre itérations, le débit des données ne peut se faire qu'à un rythme au moins huit fois inférieur à celui de leur traitement. Ceci implique qu'entre les architectures modulaire et de Von Neumann, le débit maximal d'émission des données est divisé d'un facteur au moins égal au nombre de demi-itérations utilisé. La latence est moindre pour la structure de Von Neumann (2 *n*_{*1*}*n*_{*2*} échantillons au maximum contre *(n*_{*1*}*n*_{*2*}+*L)*.*it* dans l'autre, *it* étant le nombre de demi-itérations) mais le débit est plus faible pour une même vitesse de traitement des données.

Le nombre maximal d'itérations que l'on peut intégrer dans le circuit se trouve limité par le débit que l'on souhaite atteindre et par la fréquence maximale de fonctionnement qu'autorise la technologie utilisée.

Les aspects mémoires vont maintenant être décrits en relation avec ces deux structures. Dans tous les cas, l'encombrement du circuit provient essentiellement de la taille et du nombre des mémoires utilisées. Indépendamment de l'architecture générale retenue, il est en effet indispensable de mémoriser les matrices **[R]** et **[W]** (ou **[R'])** pour toute la durée de la demi-itération en cours (une demi-itération correspond à un décodage des lignes ou des colonnes d'une matrice de données). Le traitement des données en lignes puis en colonnes oblige à prévoir une première mémoire pour recevoir les données et une seconde pour les traiter. Ces deux mémoires travaillent alternativement en mode écriture et lecture, un automate gérant le séquencement. Chaque mémoire est organisée de manière matricielle et se compose, pour un code de longueur *n*_{*1*}*n*_{*2*} et une quantification des données sur *q* bits, de plans mémoires de *q.n*_{*1*}*n*_{*2*} bits chacun.

### a) structure modulaire

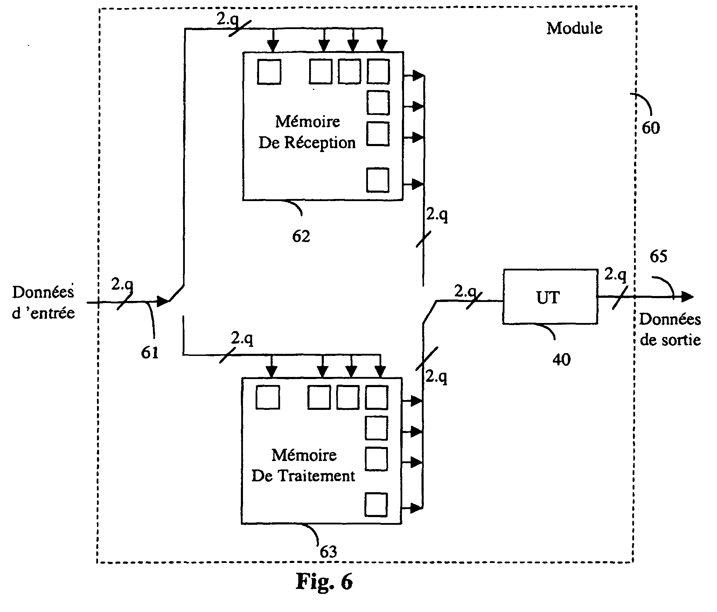

Dans le cas de la structure modulaire, l'organisation générale du circuit sur une demi-itération est celle des figures 5 et 6.

Le module 50 illustré en regard de la figure 5 contient une unité de traitement 40 (telle qu'illustrée en regard de la figure 4) et quatre mémoires :
- une mémoire 51 de mémorisation contenant les données **[R]** ;
- une mémoire 52 de traitement contenant les données **[R] ;**
- une mémoire 53 de mémorisation contenant les données **[W]** (ou **[R']** suivant l'unité de traitement); et
- une mémoire 54 de traitement contenant les données **[W]** (ou **[R']).**

Les données **[R]** 57₁ (respectivement **[W]** 57₂) codées sur *q* bits qui parviennent au module de décodage 50 sont rangées suivant les lignes de la mémoire 51 (respectivement 53) de réception fonctionnant en mode écriture, l'interrupteur logique 55₁ (respectivement 55₃) en entrée de la mémoire 51 (respectivement 53) (mis en oeuvre, par exemple sous la forme d'un bit d'adressage permettant la sélection de la mémoire 51 (respectivement 53) lors d'une opération d'écriture) étant alors fermé et l'interrupteur 56₁ (respectivement 56₃) en entrée de la mémoire 52 (respectivement 54) étant ouvert. Les données [**R**] en entrée du premier module sont directement issues du canal de transmission alors que les données **[R]** de chacun des modules suivants sont issues de la sortie **[R]** 59₁ du module précédent. Les données **[W]** en entrée du premier module sont nulles alors que les données **[W]** de chacun des modules suivants sont issues de la sortie **[W]** 59₂ du module précédent.

Parallèlement, les données de la matrice reçue précédemment sont prélevées suivant les colonnes des mémoires 52 et 54 de traitement, fonctionnant elle en mode lecture, l'interrupteur logique 56₂ (respectivement 55₄) en sortie de la mémoire 52 (respectivement 54) (mis en oeuvre, par exemple sous la forme d'un bit d'adressage permettant la sélection de la mémoire 52 (respectivement 54) lors d'une opération de lecture) étant alors fermé et l'interrupteur 56₂ (respectivement 56₄) en sortie de la mémoire 51 (respectivement 53) étant ouvert.

Une fois les mémoires de réception remplies, les mémoires de traitement passe en mode écriture (en d'autres termes, les rôles des mémoires 51 et 52 (respectivement 53 et 54) sont échangés et les interrupteurs logiques 55₁, 55₂, 55₁ et 56₂ (respectivement 55₃, 55₄, 56₃ et 56₄) « changent de position ») afin de stocker les données correspondant au mot de code suivant. En cascadant deux modules, l'un pour le décodage des colonnes et l'autre pour celui des lignes d'une matrice codée, on réalise une itération complète.

Les mémoires 51, 52, 53 et 54 utilisées peuvent être conçues sans difficulté à partir de RAM (Random Access Memory) classiques, simple port, adressables en ligne et en colonne. D'autres solutions peuvent être envisagées (registres à décalage, par exemple) mais elles sont plus encombrantes.

On note que les données échangées sur les bus de données tels qu'illustrés en regard de la figure 5 sont codées sur *q* bits alors que, selon une variante illustrée en regard de la figure 6, les données sont codées sur 2.*q* bits, chacune des données contenant alors *q* bit correspondant à une données **[R]** et *q* bits correspondant à une donnée **[W]** (ou **[R']**).

Le module 60 illustré en regard de la figure 6 permet d'effectuer une demi-itération de décodage et contient une unité de traitement 40 (telle qu'illustrée en regard de la figure 4) et deux mémoires :
- une mémoire 62 de mémorisation ou de réception contenant les données **[R]** et **[W]** (ou **[R']** dans le cas où l'unité de traitement est telle l'unité 30 illustrée en regard de la figure 3); et
- une mémoire 63 de traitement contenant les données **[R]** et **[W]** (ou **[R']**).

Les données 61 codées sur 2.*q* bits qui parviennent au module de décodage sont rangées suivant les lignes de la mémoire 62 de réception fonctionnant en mode écriture. Parallèlement, les données de la matrice reçue précédemment sont prélevées suivant les colonnes de la mémoire 62 de traitement, fonctionnant elle en mode lecture. Une fois la mémoire de réception 62 remplie, la mémoire de traitement passe en mode écriture afin de stocker les données correspondant au mot de code suivant. En cascadant deux modules, l'un pour le décodage des colonnes et l'autre pour celui des lignes d'une matrice codée, on réalise une itération complète.

Les mémoires 62, 63 utilisées peuvent être conçues sans difficulté à partir de RAM (Random Access Memory) classiques, simple port, adressables en ligne et en colonne. D'autres solutions peuvent être envisagées (registres à décalage, par exemple) mais elles sont plus encombrantes.

D'un point de vue pratique, la solution modulaire a pour avantages de permettre une fréquence de fonctionnement élevée et d'être d'une grande souplesse d'utilisation. En contrepartie, la mise en cascade de plusieurs modules entraîne un accroissement de la latence et de l'encombrement du cicuit. Ces paramètres deviennent rapidement rédhibitoires quand le nombre d'itérations et/ou la longueur du code augmente(nt).

### b) structure dite de Von Neumann

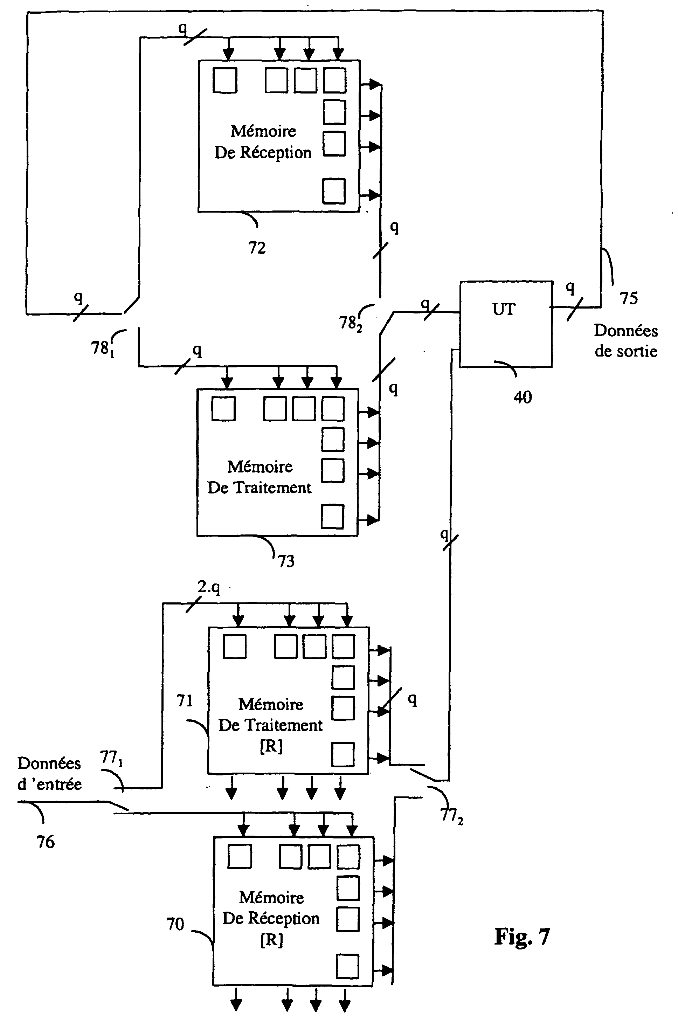

Le circuit réalise cette fois plusieurs itérations en utilisant quatre unités de mémorisation 70, 71, 72 et 73 illustrées en figure 7. On vient reboucler, sur lui-même, un module de décodage. Avec cette architecture, le circuit complet ne comprend que quatre mémoires 70, 71, 72 et 73 indépendamment du nombre d'itérations effectuées. Ces mémoires 70, 71, 72 et 73 doivent cependant pouvoir être lues et écrites aussi bien en lignes qu'en colonnes.

Les mémoires 70, 71, 72 et 73 utilisées sont des RAM classiques, simple port, dans lesquelles on peut lire ou écrire une donnée repérée par son adresse. Comme on accède directement à chaque échantillon, il est possible de décoder la matrice indifféremment suivant ses lignes ou ses colonnes. Ces mémoires sont similaires à celles retenues pour la solution modulaire mais, le circuit complet n'en comportant que quatre, le gain en surface est considérable (80% pour quatre itérations). Il faut toutefois remarquer que cette réduction de la surface est obtenue, pour une même vitesse de fonctionnement des circuits, au détriment du débit des données (divisé par au moins *it* pour *it*/*2* itérations : il faut en effet tenir compte dans ce calcul de la latence de chaque décodage élémentaire).

Les données **[R]** 76 (respectivement **[W]** 75) codées sur *q* bits sont rangées suivant les lignes de la mémoire 70 (respectivement 72) de réception fonctionnant en mode écriture, l'aiguilleur logique 77₁ (respectivement 78₁) aiguillant les données vers la mémoire 70 (respectivement 72) (mis en oeuvre, par exemple sous la forme d'un bit d'adressage permettant la sélection de la mémoire 70 (respectivement 72) lors d'une opération d'écriture). Les données **[R]** 76 en entrée sont directement issues du canal de transmission. Les données **[W]** en entrées sont nulles lors de la première demi-itération alors que les données **[W]** de chacune des demi-itérations suivantes sont issues de la sortie **[W]** 75 de la demi-itération précédente.

Parallèlement, les données **[R]** reçues précédemment sont prélevées suivant les colonnes de la mémoire 71 de traitement, fonctionnant elle en mode lecture, l'aiguilleur logique 77₂ en sortie des mémoires 71 et 70 (mis en oeuvre, par exemple sous la forme d'un bit d'adressage) permet la sélection de la mémoire 71 lors d'une opération de lecture. Parallèlement, les données **[W]** issues d'une demi-itération précédente (ou nulles s'il s'agit de la première demi-itération) sont prélevées suivant les colonnes de la mémoire 73 de traitement, fonctionnant elle en mode lecture, l'aiguilleur logique 78₂ en sortie des mémoires 72 et 73 permet la sélection de la mémoire 72 lors d'une opération de lecture.

Une fois la mémoire de réception de **[W]** remplie (c'est-à-dire à la fin de chaque demi-itération), les rôles des mémoires **[W]** de traitement et de réception sont échangés : la mémoire de traitement de **[W]** passe en mode écriture et devient mémoire de réception (en d'autres termes, les aiguilleurs logiques 78₁ et 78₂ « changent de position ») afin de stocker les données correspondant au mot de code suivant et la mémoire de réception et la mémoire de réception de **[W]** passe en mode lecture et devient mémoire de traitement.

Une fois la mémoire de réception de **[R]** remplie (c'est-à-dire à la fin de chaque opération de turbo-décodage d'un bloc si on suppose que les données sont transmises de manière continue), les rôles des mémoires **[R]** de traitement et de réception sont échangés : la mémoire de traitement de **[R]** passe en mode écriture et devient mémoire de réception (en d'autres termes, les aiguilleurs logiques 7.7₁ et 77₂ « changent de position ») afin de stocker les données correspondant au mot de code suivant et la mémoire de réception et la mémoire de réception de **[R]** passe en mode lecture et devient mémoire de traitement. Si en variante, les données sont transmises en mode paquet (ou « burst » en anglais) et si chaque paquet est à décoder en une seule fois, le décodage étant achevé avant l'arrivée d'un nouveau paquet, il n'est pas nécessaire, pour une structure de Von Neumann, d'avoir deux mémoires respectivement de traitement et de réception pour les données **[R]** mais une seule suffit.

Les mémoires 70, 71, 72 et 73 utilisées peuvent être conçues sans difficulté à partir de RAM (Random Access Memory) classiques, simple port, adressages en ligne et en colonne. D'autres solutions peuvent être envisagées (registres à décalage, par exemple) mais elles sont plus encombrantes.

On note que les données échangées sur les bus de données tels qu'illustrés en regard de la figure 7 sont codées sur *q* bits.

On note qu'en variante des modes de réalisation illustrés en regard des figures 5, 6 et 7, une unité de traitement 30 telle qu'illustrée en regard de la figure 3 peut remplacer l'unité de traitement 40. Les données de types **[W]** sont alors remplacées par des données de type **[R']** dans les mémoires.

Selon l'état de l'art, une architecture haut débit consiste à dupliquer le nombre de modules tels qu'illustrés en regard des figures 6 ou 7.

L'invention propose une nouvelle approche, particulièrement adaptée à une architecture haut débit d'un « turbo-décodeur » de codes concaténés.

On a vu que les codes concaténés avaient la propriété d'avoir des mots de code sur toutes les lignes (ou les colonnes) de la matrice C initiale.

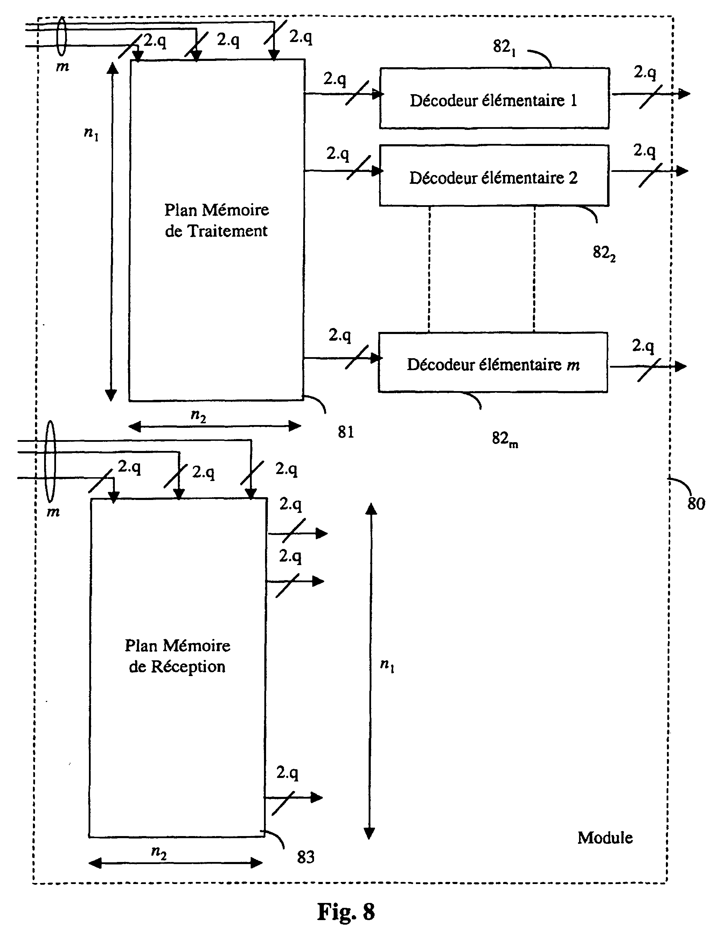

Selon l'invention, on parallélise le décodage, selon le principe illustré en figure 8, décrivant un module 80 permettant d'effectuer une demi-itération, les modules 80 pouvant être cascadés pour former une structure modulaire de turbo-décodage. La matrice 81 (plan mémoire de traitement de *n*_{*1*}.*n*_{*2*} échantillons de 2*q* bits contenant des données **[R]** et **[W]** (ou **[R']** selon le type d'unité de traitement) alimente une pluralité de décodeurs (ou unité de traitement 30 ou 40 telle qu'illustrée en regard des figures 3 et 4) élémentaires 82₁ à 82ₘ.

On a en effet dupliqué le nombre de décodeurs élémentaires du code C₁ (ou C₂) en *m* décodeurs élémentaires 82₁ à 82ₘ. On peut ainsi traiter un nombre maximal de *n*_{*1*} (ou *n*_{*2*}) mots de code à condition toutefois que les accès mémoire, en lecture ou en écriture, aient lieu à des instants différents (plusieurs points mémoire d'une matrice ne peuvent être lus ou écrits en même temps, à moins d'utiliser des RAM « multi-ports »). Cette contrainte étant respectée, il est possible de gagner un facteur *n*_{*2*} (ou *n*_{*1*}*)* dans le rapport F_{Débit}/F_{Utmax} (F_{Débit} étant le débit utile en sortie du turbo décodeur et F_{Utmax} représentant la vitesse de fonctionnement d'une unité de traitement) puisqu'il peut y avoir *n*_{*2*} (ou *n*_{*1*}) échantillons traités à un instant donné.

La matrice 83 (plan mémoire de réception de *n*_{*1*}*.n*_{*2*} échantillons de 2*q* bits) est alimentée par une pluralité de décodeurs élémentaires 82₁ à 82ₘ d'un module 80 précédent.

On note que dans le premier module, les données **[R]** sont directement issues du canal alors que les données **[W]** sont nulles (ou, en variante, on n'utilise qu'un demi-bus correspondant aux données **[R]**, en entrée des décodeurs élémentaires dans le premier module).

A chaque demi-itération, les rôles respectifs des mémoires 81 et 83 sont échangés, ces mémoires étant alternativement mémoires de traitement ou mémoire de réception.

On note que les données sont écrites suivant les colonnes des plans mémoire de réception alors qu'elles sont lues suivant les lignes dans les plans mémoire de traitement. On obtient ainsi, avantageusement un moyen d'entrelacement et de désentrelacement aisé à mettre en oeuvre (dans le cas où l'entrelaceur du turbo-codeur est uniforme, c'est-à-dire que dans l'entrelaceur les données sont écrites ligne par ligne et lues colonne par colonne) en cascadant les modules, les sorties des décodeurs élémentaires d'un module étant connectées au plan mémoire de réception du module suivant.

L'inconvénient majeur de cette architecture est que les mémoires 81 et 83 doivent fonctionner à une fréquence *m*. F_{Utmax}, si on a *m* décodeurs élémentaires en parallèle.

Selon une première variante de la structure modulaire, la matrice 81 est divisée en deux plans mémoires de traitement de *n*_{*1*}.*n*_{*2*} échantillons de *q* bits, les deux plans contenant respectivement des données **[R]** ou **[W]** (ou **[R']** selon le type d'unité de traitement). En outre, la matrice 83 est elle-même divisée en deux plans mémoire de réception de *n*_{*1*}.*n*_{*2*} échantillons de *q* bits contenant respectivement des données **[R]** ou **[W].**

En variante, le « turbo-décodeur » est réalisé selon une structure de Von Neumann. Selon cette variante, le plan mémoire de traitement est divisé en un plan de mémoire de traitement associé aux données **[R]** (si on suppose que les données sont transmises de manière continue) et un plan de mémoire de traitement associé aux données **[W]** (ou **[R']** selon le mode de réalisation de l'unité de traitement). De même, le plan mémoire de traitement est divisé en un plan de mémoire de réception associé aux données **[R]** et un plan de mémoire de réception associé aux données **[W].** De même que dans la structure illustrée en regard de la figure 7, les rôles des mémoires de traitement et de réception des données **[R]** sont échangés à chaque demi-itération et rôles des mémoires de traitement et de réception des données **[W]** sont échangés à chaque opération de turbo-décodage d'un bloc. On note cependant que selon l'invention, dans une structure de Von Neuman, les mémoires de traitement des données **[R]** et **[W]** alimentent m décodeurs élémentaires et que les sorties **[W]** de ces décodeurs sont rebouclées sur la mémoire de réception des données **[W].** Selon cette variante, si les données sont transmises en mode paquet (ou burst en anglais) et si chaque paquet est à décoder en une seule fois, le décodage étant achevé avant l'arrivée d'un nouveau paquet, il n'est pas nécessaire d'avoir deux mémoires respectivement de traitement et de réception pour les données **[R]** mais une seule suffit.

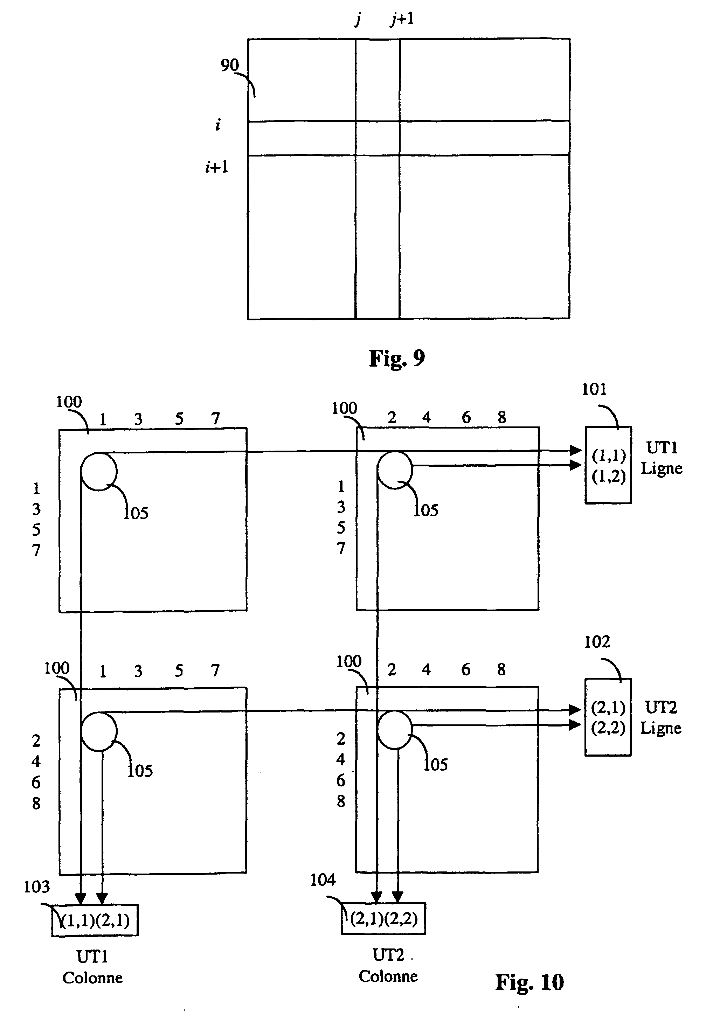

Selon un aspect avantageux de l'invention, on peut garder une même vitesse de fonctionnement de la mémoire et augmenter le débit, en mémorisant à une même adresse, plusieurs données, selon le principe illustré en figure 10. Il faut, cependant, pouvoir utiliser ces données aussi bien en ligne ou en colonne. D'où l'organisation suivante : à cette adresse vont se trouver des données adjacentes en lecture (ou écriture), aussi bien en ligne ou en colonne.

Considérons deux lignes adjacentes *i* et *i*+*1* et deux colonnes adjacentes *j* et *j*+*1* de la matrice 90 initiale, présentée en figure 9.

Les 4 échantillons (*i*,*j*), (*i*,*j*+1), (*i*+1,*j*) et (*i*+1,*j*+1) constituent un mot 105 de la nouvelle matrice 100, illustrée en figure 10 qui a 4 fois moins d'adresses (I,J) mais des mots 4 fois plus grands. Si *n*_{*1*} et *n*_{*2*} sont pairs,
alors si 1≤I≤*n*_{*1*}/*2*, *i*=2*I-1.
De même, si 1≤J≤*n*_{*2*}/*2*, *j*=2*J-1.

Pour le décodage ligne, les échantillons (*i*,*j*), (*i*,*j*+1) 101 sont affectés à une unité de traitement UT1, (*i*+1,*j*) et (*i*+1,*j*+1) 102 à une unité de traitement UT2. Pour le décodage colonne, il faut prendre (*i*,*j*), (*i*+1,*j*) 103 pour UT1 et (*i*,*j*+1), (*i*+1,*j*+1) 104 pour UT2. Si les unités de traitement savent traiter en entrée (lecture de la RAM) et en sortie (écriture de la RAM) ces couples d'échantillons dans le même temps 1/F_{UTmax},le temps de traitement de la matrice est 4 fois plus rapide que pour la matrice initiale (Figure 10).

Cette figure 10 n'est bien sûr qu'un exemple de « découpe » de la mémoire en 4 portées.

En généralisant, si un mot 105 de la nouvelle matrice 100 contient *m* échantillons d'une ligne et *l* échantillons d'une colonne, le temps de traitement de la matrice est *m*.*l* fois plus rapide avec seulement *m* unités de traitement du décodage « ligne » et *l* unités de traitement du décodage « colonne ».

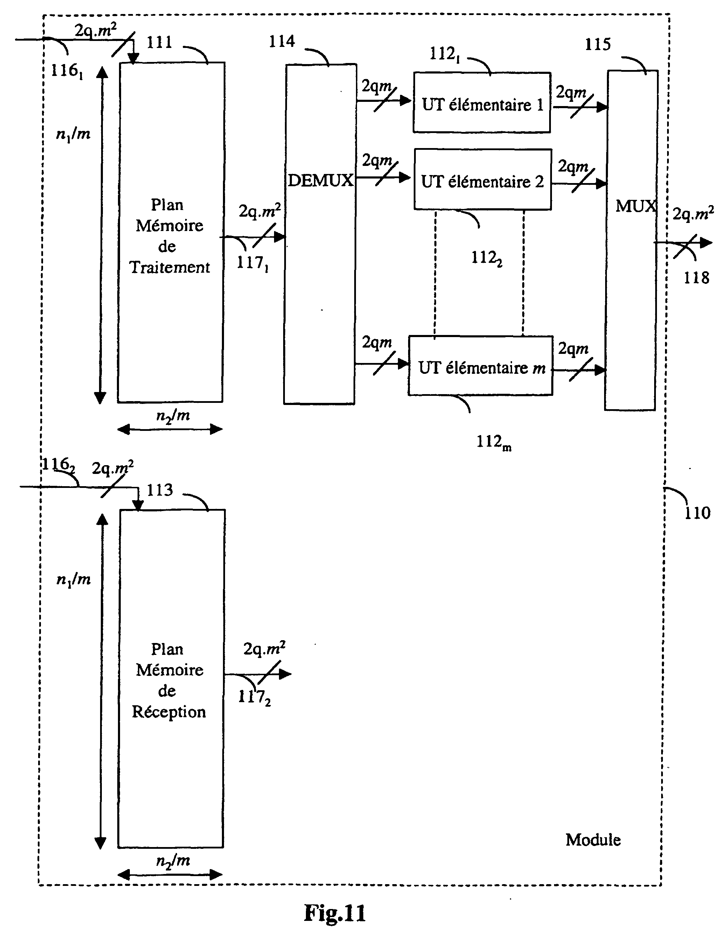

Dans le cas où les codes C₁ et C₂ sont identiques, les UT « ligne » et les UT « colonnes » le sont aussi, ainsi que cela est représenté en figure 11. Alors, *m=l* et *m* unités de traitement 112₁ à 112ₘ nécessaires (telles les unités de traitement 30 ou 40 illustrées en regard des figures 3 et 4). Un démultiplexeur 114 délivre les données de la matrice 111 (plan mémoire de traitement de *n1n2*/*m*^{*2*} mots de 2*q*.*m*^{*2*} bits) aux *m* unités de traitement (UT) élémentaires 112₁ à 112ₘ, chacune des unités de traitement recevant simultanément un échantillon de 2q*m* bits.

Un multiplexeur 115 est alimenté en échantillons de 2q*m* bits par les décodeurs élémentaires 112₁ à 112ₘ. Le multiplexeur 115 alimente ensuite, en échantillons de 2q.*m*² bits, le plan mémoire de réception 113 du module correspondant à la demi-itération suivante.

Cette organisation des matrices de données ne requiert pas d'architectures de mémoires particulières, ni une rapidité plus grande. Par ailleurs, si la complexité de l'UT reste inférieure à *m* fois celle de l'UT précédente, la complexité totale est moindre pour une vitesse *m*^{*2*} fois plus élevée (ce dernier résultat aurait pu être obtenu en utilisant *m*^{*2*} UT, comme proposé en figure 8).

La mémoire comporte *m*^{*2*} fois moins de mots que la matrice initiale C. A technologie identique, son temps d'accès sera donc moindre.

L'invention propose donc une architecture de décodage des codes concaténés, fonctionnant à haut débit. Ils peuvent être obtenus à partir de codes convolutifs ou de codes en blocs linéaires. Elle consiste essentiellement à modifier l'organisation initiale de la mémoire C afin d'accélérer la vitesse de décodage. Pendant un temps 1/F_{UTmax}, *m* échantillons sont traités dans chacun des *m* décodeurs élémentaires, ce qui permet un gain *m*^{*2*} en débit. Dans le cas où le traitement de ces *m* échantillons n'augmente pas de façon considérable la surface du décodeur élémentaire, le gain en surface est proche de *m*, lorsqu'on compare cette solution à celle nécessitant *m*^{*2*} décodeurs.

Selon une variante, le demultiplexeur 114 demultiplexe chacun des échantillons de 2q.*m*² bits reçus du plan mémoire 111 et les sérialise pour obtenir *m* séquences de *m* échantillons de 2q bits. Chacune de ces séquences est délivrée à l'une des unités de traitement élémentaires 112₁ à 112ₘ. Chacune des unités de traitement 112₁ à 112ₘ alimente alors le multiplexeur 115 en séquences d'échantillons de 2q bits. Le multiplexeur traite les *m* séquences issues simultanément des unités de traitement 112₁ à 112ₘ pour alimenter en échantillons de 2q.*m*² bits le plan mémoire de réception 113 du module correspondant à la demi-itération suivante. Selon cette variante, on obtient une vitesse de décodage *m* fois plus élevée que selon l'état de l'art à vitesse d'horloge égale, avec un seul plan mémoire de traitement dans chaque module.

Selon les modes de réalisations décrits en regard de la figure 11, les plans mémoires 111 et 113 contenant des données codées sur 2q.*m*² bits, le nombre de mots des mémoires de réception et de traitement est moindre et le temps d'accès à ces mémoires est diminué.

Bien entendu, l'invention n'est pas limitée aux exemples de réalisation mentionnés ci-dessus.

En particulier, l'homme du métier pourra apporter toute variante dans le type de mémoire utilisée, qui peuvent être par exemple des RAMs simple port ou des RAM multiports.

En outre, l'invention s'applique aussi bien au cas où les données sont transmises en mode paquets (ou burst en anglais) ou en continu.

De plus, l'invention concerne aussi bien les codes concaténés séries ou parallèles, ces codes pouvant être de type codes convolutifs ou codes en blocs.

L'invention concerne les codes constitués de deux codes concaténés mais concerne également les codes constitués de plus de deux codes concaténés.

D'une manière générale, l'invention concerne aussi tous les « turbo-codes » blocs ou non, constitués de codes élémentaires agissant sur une séquence d'information (permutée ou non), l'un au moins des mots de codes élémentaires étant constitué d'au moins deux mots de codes.

## Revendications

1. Module de décodage d'un code concaténé, correspondant à au moins deux codes élémentaires,
du type mettant en oeuvre des moyens de mémorisation dans lesquels sont stockés des échantillons de données à décoder,
**caractérisé en ce qu'**il comprend au moins deux décodeurs élémentaires (82₁ à 82ₘ, 112₁ à 112ₘ) d'au moins un desdits codes élémentaires, lesdits décodeurs élémentaires (82₁ à 82ₘ, 112₁ à 112ₘ) associés à l'un desdits codes élémentaires traitant simultanément, en parallèle, des mots de code distincts contenus dans lesdits moyens de mémorisation (81, 83, 90, 111, 113) et
**en ce que** lesdits moyens de mémorisation (81, 83, 90, 111, 113) sont organisés en cases (105), possédant chacune une adresse unique et contenant chacune au moins deux données élémentaires (101, 102, 103, 104) correspondant à un mot de code élémentaire.

2. Module de décodage selon la revendication 1, lesdits moyens de mémorisation stockant lesdites données à décoder étant organisés sous la forme d'une matrice (10) de *n*₁ lignes contenant chacune un mot de code desdits codes élémentaires et *n*₂ colonnes contenant chacune un mot de code desdits codes élémentaires,
**caractérisé en ce qu'**il comprend *n*₁ décodeurs élémentaires (respectivement *n*₂) (82₁ à 82ₘ, 112₁ à 112ₘ) alimentés chacun par une desdites lignes (respectivement colonnes) de ladite matrice (10).

3. Module de décodage selon la revendication 1, lesdits moyens de mémorisation stockant lesdites données à décoder étant organisés sous la forme d'une matrice (10) de *n*₁ lignes dont *k*₁ lignes contenant chacune un mot de code desdits codes élémentaires et *n*₂ colonnes dont *k*₂ colonnes contenant chacune un mot de code desdits codes élémentaires,
**caractérisé en ce qu'**il comprend *k*₁ décodeurs élémentaires (respectivement *k*₂) (82₁ à 82ₘ, 112₁ à 112ₘ) alimentés chacun par une desdites lignes (respectivement colonnes) de ladite matrice (10).

4. Module de décodage selon l'une quelconque des revendications 1 à 3, **caractérisé en ce que** lesdits moyens de mémorisation (81, 83, 90, 111, 113) sont organisés de façon à permettre un accès simultané à au moins deux mots de code élémentaire.

5. Module de décodage selon la revendication 4, **caractérisé en ce que** lesdits moyens de mémorisation (81, 83, 90, 111, 113) sont du type RAM simple port.

6. Module de décodage selon l'une quelconque des revendications 4 et 5, **caractérisé en ce que** chaque dite case (105) desdits moyens de mémorisation (81, 83, 90, 111, 113) possédant chacune une adresse unique contient *m.l* données élémentaires (101, 102, 103, 104) permettant d'alimenter simultanément :
- *m* décodeurs élémentaires suivant lesdites lignes selon l'une quelconque des revendications 2 et 3 ; et/ou
- *l* décodeurs élémentaires suivant lesdites colonnes selon l'une quelconque des revendications 2 et 3 ;
*m* et *l* étant des entiers strictement supérieurs à 1.

7. Module de décodage selon l'une quelconque des revendications 4 à 6, **caractérisé en ce que** lesdits mots accessibles simultanément correspondent à des lignes adjacentes et/ou à des colonnes adjacentes d'une matrice (10) initiale à *n*₁ lignes et *n*₂ colonnes, chacune des lignes et/ou colonnes adjacentes contenant un mot de code élémentaire.

8. Module selon l'une quelconque des revendications 1 à 7, **caractérisé en ce que** lesdits codes élémentaires sont le même code C.

9. Module de décodage selon l'une quelconque des revendications 1 à 8, **caractérisé en ce qu'**il effectue au moins deux opérations de décodage élémentaire.

10. Module de décodage selon l'une quelconque des revendications 1 à 9, **caractérisé en ce que** ledit code concaténé est un code concaténé série.

11. Module de décodage selon l'une quelconque des revendications 1 à 10, **caractérisé en ce que** ledit code concaténé est un code concaténé parallèle.

12. Dispositif de décodage d'un code concaténé, **caractérisé en ce qu'**il met en oeuvre au moins deux modules selon l'une quelconque des revendications 1 à 11, montés en cascade et effectuant chacun une opération de décodage élémentaire.

13. Procédé de décodage d'un code concaténé, correspondant à deux codes élémentaires,
**caractérisé en ce qu'**il comprend au moins deux étapes simultanées de décodage élémentaire d'au moins un desdits codes élémentaires, alimentées par les mêmes moyens de mémorisation (81, 83, 90, 111, 113) ; et
**en ce que** lesdits moyens de mémorisation sont organisés en cases de façon qu'un accès à une adresse unique desdits moyens de mémorisation (81, 83, 90, 111, 113) donne accès à au moins deux données élémentaires, correspondant à un mot de code élémentaire de façon à alimenter simultanément au moins deux desdites étapes de décodage élémentaire.

14. Procédé de décodage selon la revendication 13, **caractérisé en ce qu'**il est itératif.

15. Procédé de décodage selon l'une quelconque des revendications 13 et 14, **caractérisé en ce qu'**au moins certaines des données traitées sont pondérées.

## Patentansprüche

1. Modul zum Dekodieren eines mindestens zwei Elementarcodes entsprechenden verketteten Codes,
welches Speichermittel einsetzt, in denen Muster der zu dekodierenden Daten gespeichert sind,
**dadurch gekennzeichnet, dass** es mindestens zwei Elementardecoder (82₁ bis 82ₘ, 112₁ bis 112ₘ) von mindestens einen dieser elementaren Codes umfasst, wobei die mit einem der Elementarcodes assoziierten Elementardecoder (82₁ bis 82ₘ, 112₁ bis 112ₘ) gleichzeitig in paralleler Arbeitsweise verschiedene in den Speichermitteln (81, 83, 90, 111, 113) Codewörter verarbeitet, sowie dadurch,
dass die Speichermittel (81, 83, 90, 111, 113) nach Fächern (105) organisiert sind, die jeweils eine einzige Adresse besitzen und mindestens zwei einem elementaren Codewort entsprechende Elementardaten (101, 102, 103, 104) enthalten.

2. Modul zum Dekodieren nach Anspruch 1, wobei die Speichermittel für die zu dekodierenden Daten in Form einer Matrix (10) organisiert sind, welche *n*_{*1*} Zeilen, die jeweils ein Codewort der erwähnten Elementarcodes und *n*_{*2*} Spalten, die jeweils ein Codewort der erwähnten Elementarcodes enthalten, aufweist,
**dadurch gekennzeichnet, dass** es *n*_{*1*} (bzw. *n*_{*2*}) Elementardecoder (82₁ bis 82ₘ, 112₁ bis 112ₘ) umfasst, die jeweils durch eine der Zeilen (bzw. der Spalten) der Matrix (10) gespeist werden.

3. Modul zum Dekodieren nach Anspruch 1, wobei die Speichermittel für die zu dekodierenden Daten in Form einer Matrix (10) organisiert sind, welche *n*_{*1*} Zeilen aufweist, von denen *k*_{*1*} jeweils ein Codewort der erwähnten Elementarcodes enthalten sowie *n*_{*2*} Spalten, von denen *k*_{*2*} jeweils ein Codewort der erwähnten Elementarcodes enthalten,
**dadurch gekennzeichnet, dass** es *k*_{*1*} (bzw. *n*_{*2*}) Elementardecoder (82₁ bis 82ₘ, 112₁ bis 112ₘ) umfasst, die jeweils durch eine der Zeilen (bzw. der Spalten) der Matrix (10) gespeist werden.

4. Modul zum Dekodieren nach einem der Ansprüche 1 bis 3, **dadurch gekennzeichnet, dass** die Speichermittel (81, 83, 90, 111, 113) so organisiert sind, dass sie den gleichzeitigen Zugang zu mindestens zwei elementaren Codewörtern gestatten.

5. Modul zum Dekodieren nach Anspruch 4, **dadurch gekennzeichnet, dass** es sich bei den Speichermitteln (81, 83, 90, 111, 113) um RAM-Speicher mit nur einem Port handelt.

6. Modul zum Dekodieren nach einem der Ansprüche 4 oder 5, **dadurch gekennzeichnet, dass** jedes der Fächer (105) der Speichermittel (81, 83, 90, 111, 113), die jeweils eine einzige Adresse besitzen, *m·l* Elementardaten (101, 102, 103, 104) umfasst, welche die gleichzeitige Zufuhr zu den folgenden Teilen ermöglichen:
- *m* Elementardecoder nach einer der Zeilen gemäß einem der Ansprüche 2 oder 3 und/oder,
- *l* Elementardecoder nach einer der Spalten gemäß einem der Ansprüche 2 oder 3,
wobei *m* und *l* ganze Zahlen sind, die streng größer als 1 sind.

7. Modul zum Dekodieren nach einem der Ansprüche 4 bis 6, **dadurch gekennzeichnet, dass** die gleichzeitig zugänglichen Wörter nebeneinander liegenden Zeilen und/oder Spalten einer Ausgangsmatrix (10) mit *n*_{*1*} Zeilen und *n*_{*2*} Spalten entsprechen, wobei jede der nebeneinander liegenden Zeilen und/oder Spalten ein elementares Codewort enthalten.

8. Modul nach einem der Ansprüche 1 bis 7, **dadurch gekennzeichnet, dass** es sich bei den Elementarcodes um denselben Code C handelt.

9. Modul zum Dekodieren nach einem der Ansprüche 1 bis 8, **dadurch gekennzeichnet, dass** es mindestens zwei elementare Dekodieroperationen durchführt.

10. Modul zum Dekodieren nach einem der Ansprüche 1 bis 9, **dadurch gekennzeichnet, dass** der verkettete Code ein in Serie verketteter Code ist.

11. Modul zum Dekodieren nach einem der Ansprüche 1 bis 10, **dadurch gekennzeichnet, dass** der verkettete Code ein parallel verketteter Code ist.

12. Vorrichtung zum Dekodieren eines verketteten Codes, **dadurch gekennzeichnet, dass** sie mindestens zwei Module nach einem der Ansprüche 1 bis 11 einsetzt, wobei diese Module in Kaskade angebracht sind und jeweils eine elementare Dekodieroperation ausführen.

13. Verfahren zum Dekodieren eines zwei Elementarcodes entsprechenden verketteten Codes,
**dadurch gekennzeichnet, dass** es mindestens zwei gleichzeitige Schritte zum elementaren Dekodieren von mindestens einem der erwähnten Elementarcodes umfasst, die von denselben Speichermitteln (81, 83, 90, 111, 113) versorgt werden, und dadurch,
dass die Speichermittel nach Fächern organisiert sind, so dass der Zugang zu einer einzigen Adresse der Speichermittel (81, 83, 90, 111, 113) den Zugang zu mindestens zwei einem elementaren Codewort entsprechenden Elementardaten zulässt, um gleichzeitig mindestens zwei der Schritte zum elementaren Dekodieren zu versorgen.

14. Dekodierverfahren nach Anspruch 13, **dadurch gekennzeichnet, dass** es iterativ ist.

15. Dekodierverfahren nach einem der Ansprüche 13 oder 14, **dadurch gekennzeichnet, dass** es sich bei mindestens einigen der verarbeiteten Daten um gewichtete Daten handelt.

## Claims

1. Module for decoding a concatenated code, corresponding to at least two elementary codes,
of the type implementing storage means in which data samples to be decoded are stored,
**characterized in that** it comprises at least two elementary decoders (82₁ to 82ₘ, 112₁ to 112ₘ) of at least one of the said elementary codes, the said elementary decoders (82₁ to 82ₘ, 112₁ to 112ₘ) being associated with one of the said elementary codes carrying out the simultaneous processing, in parallel, of the separate code words contained in the said storage means (81, 83, 90, 111, 113) and
**in that** the said storage means (81, 83, 90, 111, 113) are organized in cells (105), each having a unique address and each containing at least two elementary data items (101, 102, 103, 104) corresponding to an elementary code word.

2. Decoding module according to Claim 1, the said storage means storing the said data to be encoded being organized in the form of a matrix (10) of *n*₁ rows, each containing a code word of the said elementary codes, and *n*₂ columns, each containing a code word of the said elementary codes,
**characterized in that** it comprises *n*₁ (and *n*₂ respectively) elementary decoders (82₁ to 82ₘ, 112₁ to 112ₘ), each supplied by one of the said rows (or columns respectively) of the said matrix (10).

3. Decoding module according to Claim 1, the said storage means storing the said data to be encoded being organized in the form of a matrix (10) of *n*₁ rows, including *k*₁ rows each containing a code word of the said elementary codes, and *n*₂ columns, including *k*₂ columns each containing a code word of the said elementary codes,
**characterized in that** it comprises *k*₁ (and *k*₂ respectively) elementary decoders (82₁ to 82ₘ, 112₁ to 112ₘ), each supplied by one of the said rows (or columns respectively) of the said matrix (10).

4. Decoding means according to any one of Claims 1 to 3, **characterized in that** the said storage means (81, 83, 90, 111, 113) are organized in such a way as to permit simultaneous access to at least two elementary code words.

5. Decoding module according to Claim 4, **characterized in that** the said storage means (81, 83, 90, 111, 113) are of the single-port RAM type.

6. Decoding module according to any one of Claims 4 and 5, **characterized in that** each said cell (105) of the said storage means (81, 83, 90, 111, 113), each having a unique address, contains *m.l* elementary data items (101, 102, 103, 104), permitting a simultaneous supply to be made to:
- *m* elementary decoders along the said rows according to any one of Claims 2 and 3; and/or
- *l* elementary decoders along the said columns according to any one of Claims 2 and 3;
*m* and *l* being integers which are greater than 1 in all cases.

7. Decoding module according to any one of Claims 4 to 6, **characterized in that** the said simultaneously accessible words correspond to adjacent rows and/or adjacent columns of an initial matrix (10) with *n*₁ rows and *n*₂ columns, each of the adjacent rows and/or columns containing an elementary code word.

8. Module according to any one of Claims 1 to 7, **characterized in that** the said elementary codes are the same C code.

9. Decoding module according to any one of Claims 1 to 8, **characterized in that** it carries out at least two elementary decoding operations.

10. Decoding module according to any one of Claims 1 to 9, **characterized in that** the said concatenated code is a serial concatenated code.

11. Decoding module according to any one of Claims 1 to 10, **characterized in that** the said concatenated code is a parallel concatenated code.

12. Device for decoding a concatenated code, **characterized in that** it implements at least two modules according to any one of Claims 1 to 11, mounted in cascade and each carrying out an elementary decoding operation.

13. Method for decoding a concatenated code, corresponding to two elementary codes,
**characterized in that** it comprises at least two simultaneous steps for the elementary decoding of at least one of the said elementary codes, supplied by the same storage means (81, 83, 90, 111, 113); and
**in that** the said storage means are organized in cells in such a way that access to a unique address of the said storage means (81, 83, 90, 111, 113) gives access to at least two elementary data items corresponding to an elementary code word in such a way as to supply simultaneously at least two of the said elementary decoding steps.

14. Decoding method according to Claim 13, **characterized in that** it is iterative.

15. Decoding method according to any one of Claims 13 and 14, **characterized in that** at least some of the processed data are weighted.
